# EUROPEAN PATENT SPECIFICATION

(11) **EP 3 975 214 B1**
(45) Date of publication and mention of the grant of the patent: **23.04.2025**
(21) Application number: 21197788.9
(22) Date of filing: 20.09.2021
(51) Int. Cl.: H01H 1/00, H01H 71/04

(54) **SWITCHING ASSEMBLY AND METHOD FOR MEASURING A POSITION OF A CONTACT BRIDGE IN A SWITCHING ASSEMBLY**
SCHALTANORDNUNG UND VERFAHREN ZUR POSITIONSMESSUNG EINER KONTAKTBRÜCKE IN EINER SCHALTANORDNUNG
ENSEMBLE DE COMMUTATION ET PROCÉDÉ DE MESURE D'UNE POSITION D'UN PONT DE CONTACT DANS UN ENSEMBLE DE COMMUTATION

(30) Priority: 23.09.2020 DE 102020124802
(43) Date of publication of application: 30.03.2022
(73) Proprietor: TE Connectivity Germany GmbH, 64625 Bensheim (DE)
(72) Inventor: Lindner, Christian, 64625 Bensheim (DE); Rahn, Bernd, 64625 Bensheim (DE); Sandeck, Peter, 64625 Bensheim (DE); Kroeker, Matthias, 64625 Bensheim (DE); Koch, Harry, 64625 Bensheim (DE)
(74) Representative: Grünecker Patent- und Rechtsanwälte PartG mbB

(56) References cited:
- WO-A1-2006/133659
- WO-A1-2019/141529
- DE-A1- 10 260 249
- DE-A1- 102014 212 132
- US-A1- 2018 308 650

## Description

The present invention relates to a switching assembly and a method for measuring a position of a contact bridge in a switching assembly.

Switching assemblies are used in particular for the high-voltage and/or high-current range. Known embodiments have two contacts and a contact bridge, which is movable from a bridging position, in which the contact bridge connects the contacts to one another in an electrically conductive manner, to a separated position, in which the contacts are electrically separated from one another, the switching assembly comprising a detector with at least one detector element by means of which the presence of the contact bridge at the separated position and/or the bridging position is detectable. Often, however, a fault state in which, for example, one of the contacts is welded to the contact bridge is not detected or is incorrectly declared as open or closed. This makes such switching assemblies unreliable. In other known switching assemblies, the switching state is determined by applying a voltage in the circuit and determining the contact state by measuring the voltage drop across the contacts. For this purpose, if there is more than one switching element in the circuit, it will be necessary to close the switching element that is not to be examined. This is laborious.

DE 102 60 249 A1, WO 2019/141529 A1, DE 10 2014 212132 A1 and WO 2006/133659 A1 show solutions in which the position of the contact bridge is measured. US 2018/308650 A1 describes a switching arrangement.

It is the object of the present invention to provide a solution that is more reliable and less difficult.

According to the present invention, the solution is accomplished in that the detector comprises at least one two-point controller with a first switching point and a second switching point for the detector element, wherein at least one of the switching points is associated with a position of the contact bridge between the bridging position and the separated position.

In the case of a method according to the present invention for measuring a position of a contact bridge in a switching assembly with two contacts, the solution is accomplished in that, when the contact bridge moves from the bridging position to the separated position, switching from a first output signal to a second output signal takes place at a first switching point and, when the contact bridge moves from the separated position to the bridging position, switching from the second output signal to the first output signal takes place at a second switching point that is different from the first switching point, at least one of the switching points being assigned to a position of the contact bridge between the bridging position and the separated position.

The solution according to the present invention guarantees that, during a movement away from the separated position or away from the bridging position, the detector will not switch until an area, in which a fault may occur, e.g. incomplete separation of a contact bridge that is welded to a contact, has been swept. This allows a reliable detection of a fault state. The switching assembly and the method, respectively, are thus rendered more reliable.

The solution according to the present invention can be improved still further with the following further developments and embodiments, each of which is advantageous in itself and can be combined with other further developments and embodiments in an arbitrary manner.

According to first advantageous embodiment, both switching points may be assigned to positions of the contact bridge between the bridging position and the separated position. An area in which a fault may occur may here be located between the two switching points. One of the switching points may be assigned to a position of the contact bridge that is very close to the bridging position or the separated position. The other switching point may be further away from the separated position or the bridging position.

According to an advantageous embodiment, the other switching point may be assigned to the position of the contact bridge at the bridging position or the separated position. This allows a reliable detection of the contact bridge at the bridging position or the separated position.

According to a further advantageous embodiment, the separated position or the bridging position may lie in an area located between the positions assigned to the first switching point and the second switching point. The reliability can thus be increased still further, since switching will then only take place, when the contact bridge has definitely moved beyond a position associated with the bridging position or the separated position. This may be of advantage e.g. in cases where the contact bridge is movably supported on a further element.

According to an advantageous embodiment, one of the switching points may be assigned to a position located approximately at half the overtravel. In this way, it can be ensured that the closed condition has definitely been reached, when the switching point is reached.

In a compact embodiment, the two-point controller may be part of the detector element. It may be integrated in the detector element or define a component together with the detector element.

In alternative embodiments, the two-point controller may be an element separate from the detector element. It may, for example, be an independent component.

The two-point controller may be implemented in hardware or software. It may be a physical component or it may merely be configured as a software module.

The two-point controller may be programmable. In particular, the first and the second switching point may be programmable or adjustable. The switching points may, for example, be defined as points at which the measurement signal strength falls below or exceeds a certain value.

An output signal of the detector element may be discrete. This allows, for example, easy integration into a digital system. In particular, the output signal may comprise two levels.

According to an advantageous embodiment, the contact bridge may be spring-mounted on a contact bridge carrier. In particular, the contact bridge may be spring-mounted along a switching direction. This allows reliable contacting with a spring force.

For easy and simple measurement, the switching assembly may comprise an indicator element, the position of which is detectable by the detector element. Because the detector element detects the position of the indicator element, the detector can switch depending on the position of the indicator element. The switching operation may here be path-dependent.

According to an advantageous embodiment, the switching assembly may comprise a further detector element. This can make the switching assembly even more reliable.

The further detector element can do without a two-point controller and/or hysteresis.

Advantageously, the switching assembly may comprise two two-point controllers for each detector element. The switching assembly can thus be rendered more reliable.

A first detector element may be assigned to the bridging position and a second detector element may be assigned to the separated position. Advantageously, both the first detector element and the second detector element may have a two-point controller.

According to an embodiment allowing a short measurement path, the detector elements may be tangentially displaced with respect to the switching direction.

The existence of two different switching points can be referred to as hysteresis. A hysteresis region of the two-point controller may be rectangular, so as to allow clearly defined switching operations.

With two detector elements, each with two output signals, a total of four combinations of output signals are possible. One of these combinations can indicate that the switching assembly is definitely open, i.e. that the contact bridge has definitely reached the separated position. One of the combinations can indicate that the switching assembly is definitely closed, i.e. that the contact bridge has definitely arrived at the bridging position. At least one of these combinations can indicate that the switching assembly is in a fault state, i.e. that the contact bridge is neither definitely at the separated position nor definitely at the bridging position. This may, for example, correspond to a state in which one of the contacts is welded. One of the combinations may indicate that the detector has a defect, e.g. if the combination of the signals of the two detector elements does not correspond to any possible position between the separated position and the bridging position.

Alternatively or additionally, a combination of output signals of at least one detector element with at least one further signal, in particular a switching signal, may be evaluated. The switching signal may, for example, be an excitation signal for a switching coil that moves the contact bridge directly or indirectly. If, for example, the excitation signal is set such that the switching coil and thus the contact bridge should be in the separated position, without this separated position being clearly detected by the detector, a defect can be inferred from this.

According to an advantageous embodiment, the at least one detector element may be arranged outside a switching chamber. This will protect the detector element e.g. against electric arcs and/or high voltages that could otherwise damage it. In the case of two detector elements, both detector elements are advantageously arranged outside the switching chamber, in particular with further sensitive parts of the detector.

The indicator element may be arranged within the switching chamber, so as to allow, for example, direct coupling with moving parts.

The indicator element may comprise a permanent magnet. The indicator element may consist of a permanent-magnetic material. For example, the indicator element may comprise rare earths so as to produce a high magnetic field strength that can easily be detected.

According to an advantageous embodiment, the indicator element may be a separate element connected to other, in particular movable, parts of the switching assembly. The indicator element may be connected directly or indirectly in a motion-transmitting manner to parts of the switching assembly that move during the switching operation, e.g. to the contact bridge carrier.

The indicator element may be connected to other parts, e.g. by means of adhesive bonding, welding or soldering. Also a form-fit or a force-fit connection with other parts is possible.

According to a further embodiment, the indicator element may be part of the contact bridge and/or of the contact bridge carrier. A compact structural design will thus be possible. For example, part of the contact bridge or of the contact bridge carrier may be magnetized and thus generate a magnetic field that can be measured with a detector element. In the case of other measurement methods, reflective surfaces, for example, may be used as an indicator element, e.g. in the case of an optical measurement or in a measurement with ultrasound.

In order to allow measurement of a magnetic field, the at least one detector element may comprise a Hall sensor.

For easy mounting, the at least one detector element may be arranged on a printed circuit board. Further elements, such as a two-point controller, a control unit or an evaluation unit, may be provided on the printed circuit board.

In a space-saving embodiment, the at least one detector element may be arranged in a slot in a blow magnet assembly. A blow magnet assembly can be used to extinguish arcs during opening.

The blow magnet assembly may comprise a single broad magnet on one side and two sub-magnets on another side. The at least one detector element may be arranged between the two sub-magnets so as to save space.

Advantageously, the at least one detector element may measure in a contact-free manner.

According to an advantageous embodiment, a magnetic field generated by the indicator element may run at the detector element antiparallel to a magnetic field generated by the blow magnet assembly, when the indicator element is positioned before the detector element.

A magnetic field of the indicator element may dominate when the contact bridge is at the one position, e.g. when the indicator element is positioned before the detector element. A magnetic field of the blow magnet assembly may dominate when the contact bridge is at the other position, e.g. when the indicator element is not positioned before the detector element.

In order to achieve a good signal-to-noise ratio, the difference in the signal strengths used in the measurement may be greater than the signal strength that is necessary for getting from the first switching point to the second switching point of the detector element. The ratio may, in particular, be greater than 2:1, especially greater than 5:1 or greater than 10:1.

In particular, the area corresponding to the first switching point and the second switching point may be located centrally in an area between the occurring minimum and maximum signal strengths. This means that interference from outside can have little influence on the measurement. In order to keep an influence of interference low, the area corresponding to the first switching point and the second switching point may have a certain minimum distance to the occurring minimum and maximum signal strengths. The minimum distance may correspond to about at least 200% of the width between the first switching point and the second switching point, preferably to at least 300%, especially to at least 500%. The minimum distance may correspond to about at least 200% of the signal strength of an expected interference signal, preferably to at least 300%, especially to at least 500%.

A switching process may take place around a zero point of the magnetic field. The first switching point may be assigned to a magnetic field in a first direction, the second switching point may be assigned to a magnetic field in a second direction opposite to the first direction. The absolute values of the switching points may here be equal. For example, the first switching point may be at +0.2 mT and the second switching point may be at -0.2 mT. Structurally implementing such an embodiment can be particularly easy, since available detector elements, which need not be programmed to special switching values, can simply be used.

In the following, the invention will be explained exemplarily in more detail on the basis of advantageous embodiments with reference to the drawings.

The Figures show:
- Fig. 1: a schematic sectional view through a switching assembly from the side;
- Fig. 2: a schematic sectional view through a switching assembly from above;
- Fig. 3: a schematic view of a detector;
- Fig. 4: a schematic perspective view of a contact bridge carrier with an indicator element;
- Fig. 5: a schematic perspective view of a switching assembly;
- Fig. 6: a schematic, sectional perspective view of a switching assembly;
- Fig. 7: a schematic view of two magnetic field curves in the switching assembly;
- Fig. 8: a schematic view of a switching behaviour of a detector element;
- Fig. 9: a schematic view of possible switching behaviours of two detector elements of a switching assembly;
- Fig. 10: a schematic view of a switching behaviour of a detector element and the movement characteristics of the contact bridge and of the contact bridge carrier.

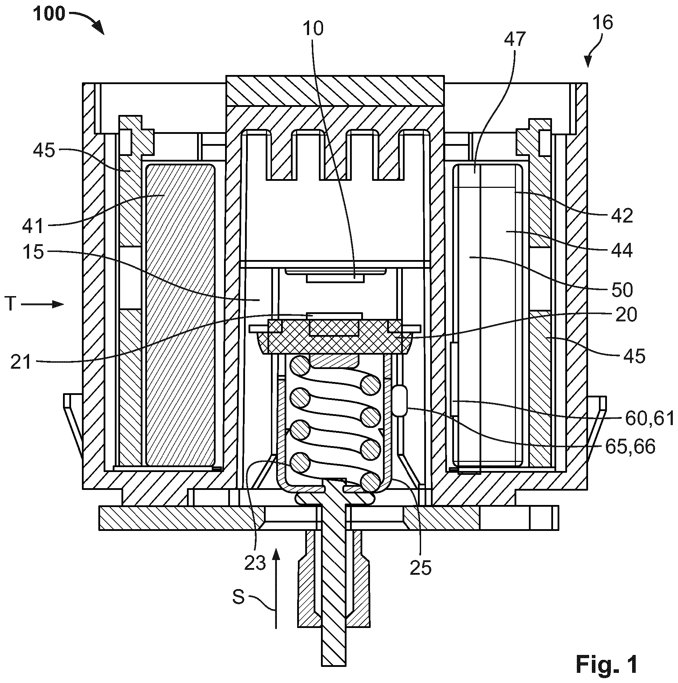

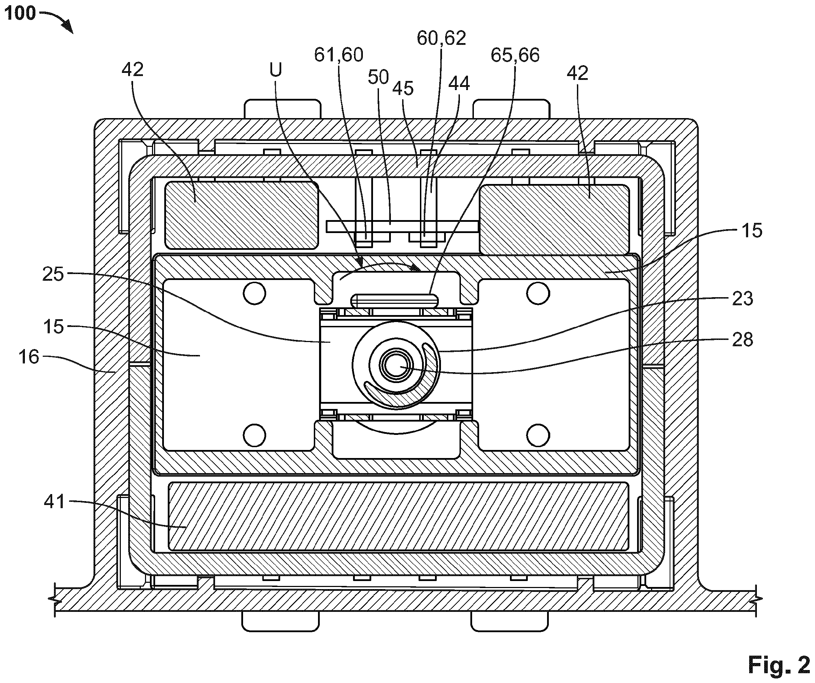

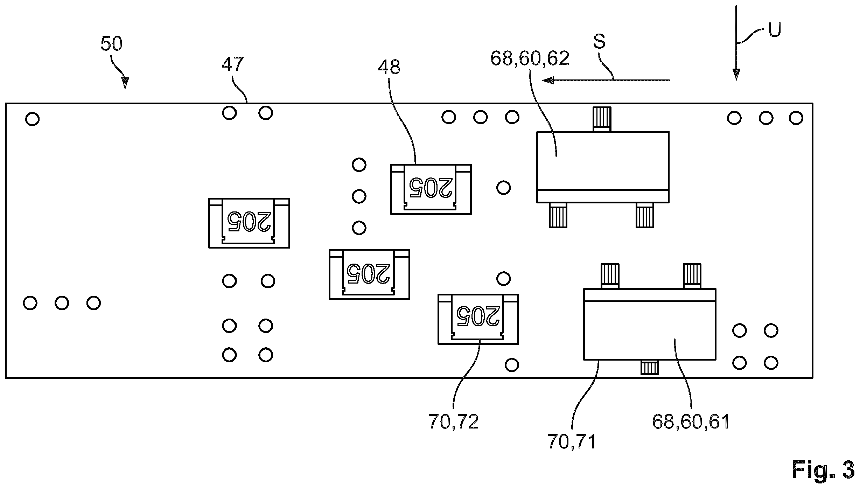

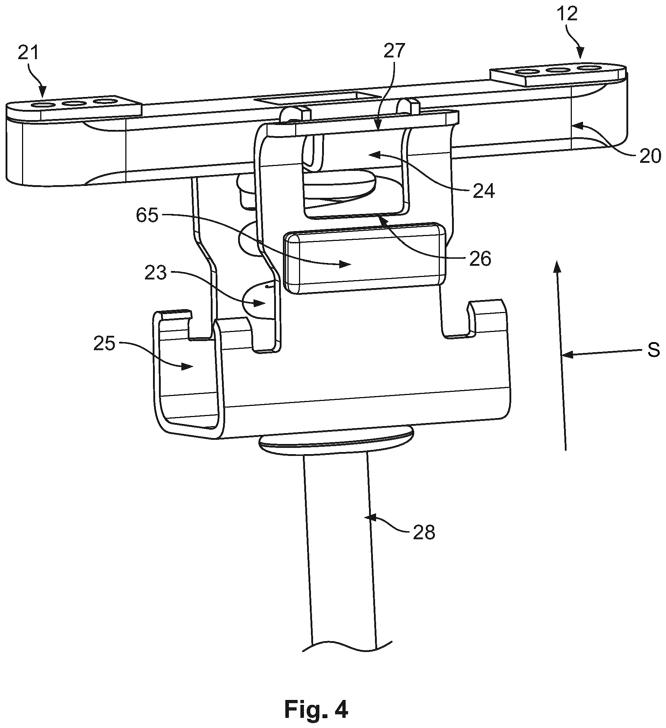

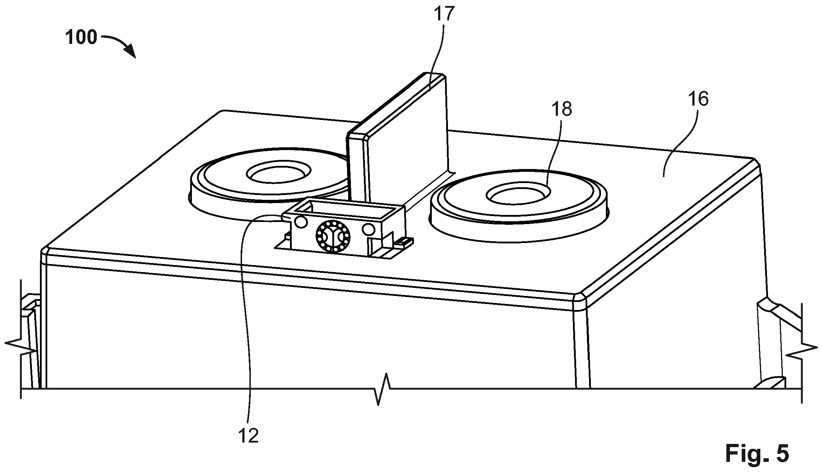

Fig. 1 to 6 show a first embodiment of a switching assembly 100. The switching assembly 100 comprises a housing 16. Two terminal elements 18 are accessible from the outside for connecting a circuit to be switched. The two terminal elements 18 have provided between them a partition 17 for electrical insulation. In addition, a connector 12 of a detector 50 projects from the housing 16. Contacts 10 provided inside are each connected to a respective terminal element 18 in an electrically conductive manner. In order to connect the two contacts 10 to each other, a movable contact bridge 20 is provided. The contact bridge 20 consists of an electrically conductive material and is adapted to be connected to the contacts 10 at two contact points 21, so as to close the circuit.

The contact bridge 20 is movably mounted on and partially supported in a contact bridge carrier 25. A projection 24 on the contact bridge 20 is movable along a switching direction S in a motion link 26 of the contact bridge carrier 25. The contact bridge carrier 25 has formed thereon a stop 27 on one end, which limits the movement of the projection 24 and thus of the contact bridge 20 along the switching direction S.

The contact bridge 20 is preloaded relative to the contact bridge carrier 25 by a spring 23 acting along the switching direction S. At the separated position T shown in Fig. 1, the contact bridge 20 is preloaded towards the contact elements 10. The contact bridge carrier 25 is fixedly mechanically connected to a drive rod 28, which may be driven e.g. by a coil that is not shown in detail. During a movement along a switching direction S, the contact bridge 20 reaches a bridging position B, at which the contact bridge 20 conductively connects the contacts 10. After contact has been established, the spring 23 is compressed and generates a contact force between the movable contact points 21 and the fixed contacts 10, so as to ensure reliable contacting. In this process, the contact bridge 20 moves relative to the contact bridge carrier 25.

In order to determine the position of the contact bridge 20, the switching assembly 100 comprises a detector 50. The detector 50 has two detector elements 60, which detect a magnetic field 96 emitted by an indicator element 65. The detector 50 includes a first detector element 60, 61 and a second detector element 60, 62 and is arranged outside a switching chamber 15, so that it will be protected against high voltages and arcs. The indicator element 65, which is configured as a permanent magnet 66, is arranged within the switching chamber 15 and is insensitive to high voltages and arcs that may occur when the contacts 10 are being separated from the contact bridge 20.

The indicator element 65 is fixedly connected to the contact bridge carrier 25. It is attached to the side of the contact bridge carrier 25, e.g. by means of adhesive bonding, welding or a form-fit. The indicator element 65 may, for example, comprise rare earths, so as to generate high magnetic field strengths.

The first detector element 60, 61 is displaced relative to the second detector element 60, 62 along the switching direction S. The first detector element 60, 61 may be assigned to the separated position T. The second detector element 60, 62 may be assigned to the bridging position B.

In addition, the first detector element 60, 61 and the second detector element 60, 62 are displaced along a tangential direction U, so as to allow a small displacement along the switching direction S.

The detector elements 60, 61, 62 are arranged on a printed circuit board 47 on which also other components 48 are provided. The detector elements 60 are configured as Hall sensors 68 which detect magnetic fields.

The detector 50 further comprises two-point controllers 70 assigned to the detector elements 60. For example, a first two-point controller 70, 71 may be integrated in a detector element 60, 61. In a further embodiment, a two-point controller 70, 72 may be arranged outside the detector element 60, but may operatively be connected thereto.

The two-point controllers 70 are configured to have a first switching point 111, 121 and a second switching point 112, 122 that is different from the first switching point 111, 121. One of the two switching points 111, 112, 121, 122 is assigned to a position of the contact bridge 20 between the bridging position B and the separated position T. This position is especially outside a fault area, in which a fault may occur. For example, a contact 10 may weld to a contact point 21 due to excessively high currents. In an attempt to cause the contact bridge 20 to move from the bridging position B to the separated position T, this weld may have the effect that the contact bridge 20 moves only slightly away from the bridging position B, e.g. only a few hundred micrometers. Although the contact bridge 20 has then left the bridging position B, the circuit has not yet been reliably separated. Due to the fact that one of the switching points 111, 112, 121, 122 lies beyond an area in which a faulty contact bridge 20 can move, it is guaranteed that the contact bridge 20 has actually become detached completely when the switching operation takes place. For example, a switching point 111, 112, 121, 122 may be assigned to a position, at which the contact bridge 20 is one millimeter, two millimeters, or five millimeters away from the bridging position B.

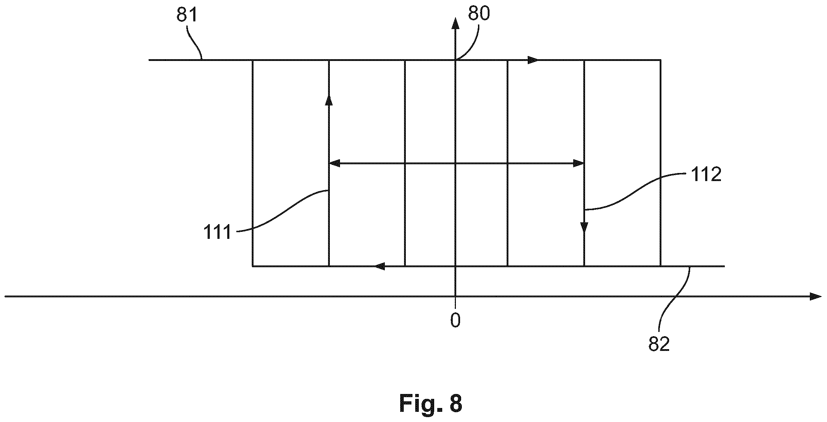

An explanation of the switching behaviour can be illustrated by Fig. 8. There, it can be seen that a two-point controller 70 of a detector element 60 has a first switching point 111 and a second switching point 112. The measured variable relevant to the switching operation, e.g. a measured magnetic field, is plotted on the abscissa. The output signal 80 of the detector element 60 is shown on the ordinate. The output signal 80 may exhibit a first output signal 81 with a first signal level or a second output signal 82 with a second signal level. In particular, it may be a digital output signal.

The two-point controller 70 exhibits a hysteresis. If the measured variable is varied, the output signal 80 will be path-dependent. If the signal strength of the measured variable increases, switching from the first output signal 81 to the second output signal 82 will take place at a second switching point 112. If the signal strength of the measured variable is reduced again, switching back to the first output signal 81 will only take place at a first switching point 111. It follows that the first switching point 111 and the second switching point 112 are spaced apart along the measured variable.

Advantageously, the switching process takes place around a zero point of the magnetic field. The first switching point 111 is assigned to a magnetic field in a first direction, the second switching point 112 is assigned to a magnetic field in a second direction opposite to the first direction. The absolute values of the magnetic fields belonging to the switching points 111, 112 are here equal. For example, the first switching point 111 may be at +0.2 mT and the second switching point 112 may be at -0.2 mT. Structurally implementing such an embodiment can be particularly easy, since available detector elements, which need not be programmed to special switching values, are simply used.

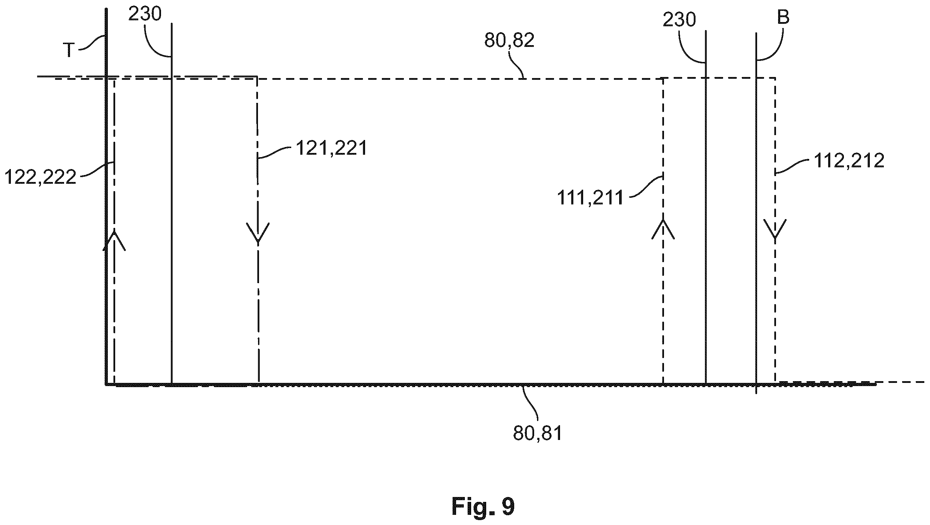

Fig. 9 shows various embodiments for the positions of the switching points 111, 112, 121, 122 and the associated positions 211, 212, 221, 222. In the embodiment shown, at the separated position T, the second switching point 122 and the associated position 222 are arranged close to the separated position T. The separated position T and the switching point 122 and its associated position 222 may also coincide, so as to allow a reliable detection of the separated position T.

The first switching point 121 and its associated position 221 are located between the separation position P and the bridging position B. Furthermore, the first switching point 121 and its associated position 221 are located between the second switching point 122 and its associated position 222 and the two switching points 111, 112 and their associated positions 211, 212 of the further detector element 60, which is assigned to the bridging position B.

A boundary 230 of the malfunction area is located between the two switching points 121, 122 and between their associated positions 221, 222. This ensures that the detector will switch the detector element 60 only to the respective other output signal 81, 82, when the malfunction area 230 has been swept.

In the case of the detector element 60 assigned to the bridging position B, the switching points 111, 112, 121, 122 are arranged in a slightly different manner. Even though the first switching point 111 and its associated position 211 are again arranged beyond a malfunction area, so that the boundary 230 of the malfunction area is located between the two switching points 111, 112 and between their associated positions 211, 212, the second switching point 112 and its associated position 212 are arranged behind the bridging position B. The bridging position B is thus located between the first switching point 111 and the second switching point 112 and between the respective positions 211, 212 associated with these switching points. It follows that switching to the other output signal 81 will here only take place after the contact bridge 20 has reached the bridging position B. This is possible due to the fact that the contact bridge 20 is spring-mounted in the contact bridge carrier 25 and the indicator element 65 is arranged on the contact bridge carrier 25.

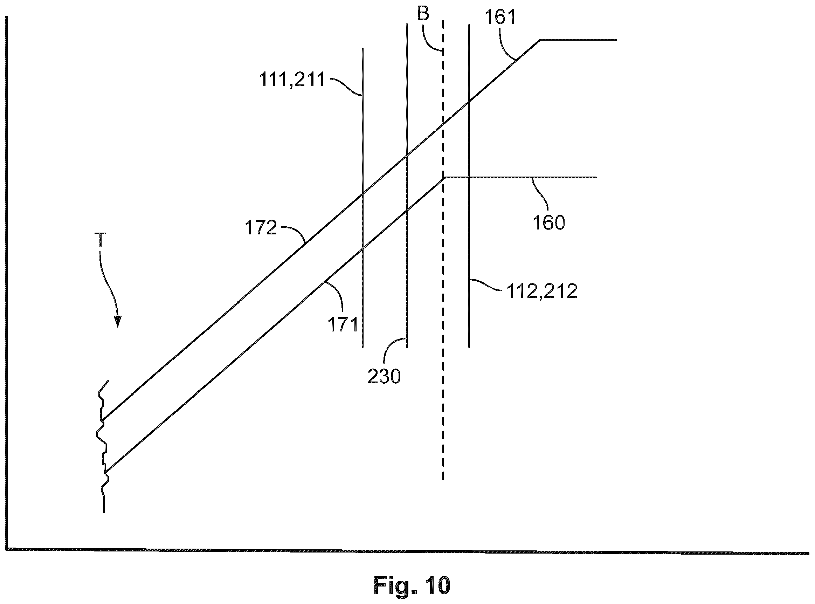

Fig. 10 shows the movement behaviour of the individual components corresponding to the behaviour just described. A movement of a driving element, e.g. the drive rod 28, is plotted to the right. The respective positions of the moving components are plotted towards the top. A movement curve 171 of the contact bridge 20 is essentially linear and proportional up to a point at which the bridging position B is reached. From there on, the position of the contact bridge 20 does not change anymore, since it is blocked by the contact points 21 entering into contact with the contacts 10. In contrast, the movement curve 172 of the contact bridge carrier 25 shows that, after having reached the bridging position B, the contact bridge carrier 25 continues to move linearly and proportionally until it finally reaches an end position as well.

In order to be sure that the bridging position B has definitely been reached, one of the switching points 112 and its associated position 212 may be located behind the bridging position B. The switching point 112 and its associated position 212 are thus located in a contact area 160 of the contact bridge and in an overtravel area 161 of the contact bridge carrier 25. For example, the switching point 112 may be located approximately centrally in the overtravel area 161, i.e. approximately at half of the spring travel between contact establishment and full compression of the spring 23.

The bridging position B is thus located between the first switching point 111 and the second switching point 112 and between their associated positions 211, 212. In addition, the boundary 230 of the malfunction area is again located between the two switching points 111, 112 and between their associated positions 211, 212. The boundary 230 is here located between the bridging position B and the first switching point 111 and its associated position 211, respectively.

From the combination of the output signals 80 of the two detector elements 60, it can be inferred in which state the switching assembly 100 is. For example, if it can be inferred from the output signal 80 of the detector element 60 assigned to the separated position T that the contact bridge 20 has left the separated position T, while from the output signal 80 of the detector element 60 assigned to the bridging position B it can be inferred that the contact bridge 20 has not yet arrived at the bridging position B, a defect may exist.

Also a combination of the output signals 80 with a control signal may be used for the purpose of analysis. For example, it can be concluded that a malfunction, such as a weld, exists, if the control signal is such that the contact bridge 20 should move away from the bridging position B, but no corresponding output signal 80 is present at the detector element 60 assigned to the bridging position B.

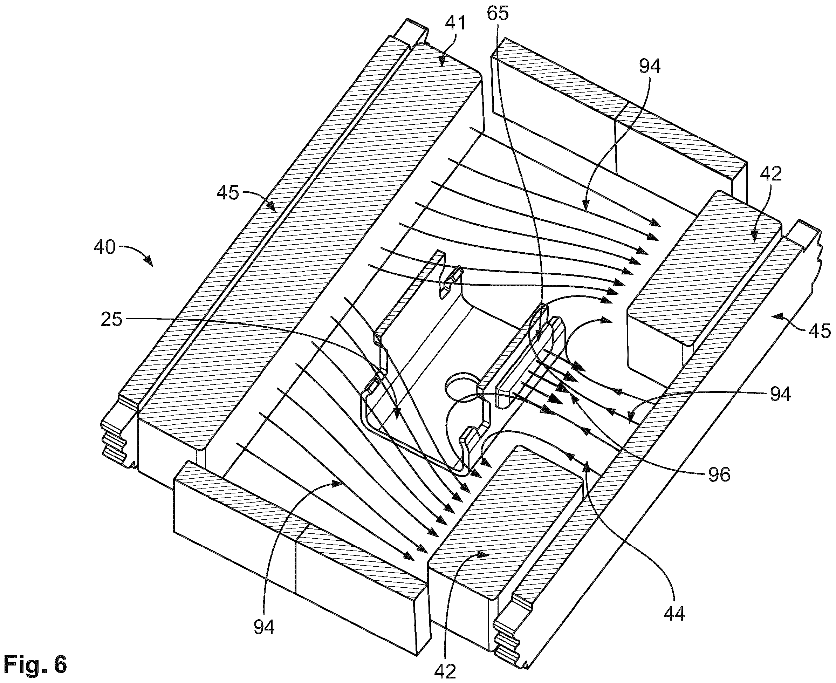

Fig. 6 illustrates the magnetic measurement principle that may be used in an exemplary embodiment. The switching assembly 100 comprises a blow magnet assembly 40, which comprises a first broad magnet 41 on one side and two sub-magnets 42 on the other side of the switching chamber 15. The blow magnet assembly 40 generates in the switching chamber a magnetic field 94 that deflects and thus extinguishes the arcs occurring when the contact bridge 20 is being separated from the contacts 10. Magnetic field conducting elements 45 close the magnetic circuit.

The indicator element 65 generates an additional magnetic field 96. Depending on the position of the indicator element 65, the detector elements 60 will see either an inwardly directed total magnetic field or an outwardly directed total magnetic field. The total magnetic field is here established by the superposition of the two magnetic fields 94, 96.

The detector 50 is arranged in a slot 44 between the two sub-magnets 42.

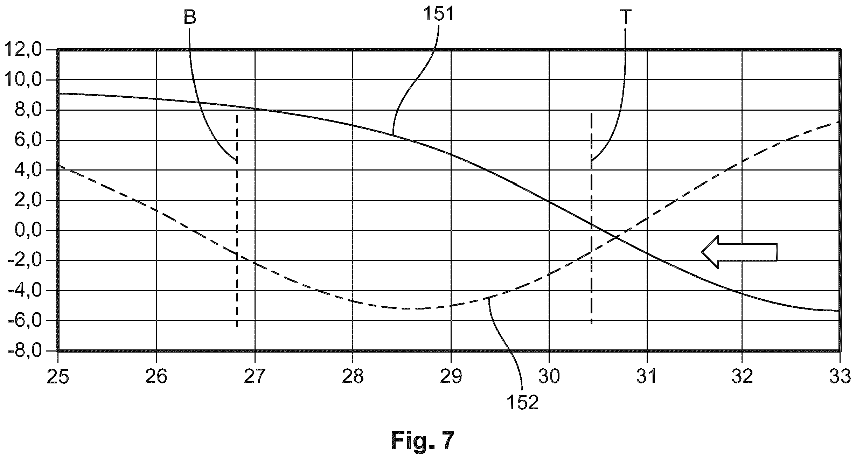

In Fig. 7, the magnetic fields in the area of the detector 50 are shown. A first curve 151 corresponds here to the situation in which the indicator element 65 is arranged before the detector element 60, which is assigned to the separated position T. The second curve 152 corresponds to the situation in which the indicator element 65 is arranged before the detector element 60, which is assigned to the bridging position B. The curves 151, 152 show the respective magnetic field that is measured by a probe guided along the switching direction S. The magnetic field changes from a respective positive direction to a respective negative direction, with the transition being in the vicinity of the bridging position B or the separated position T. If the magnetic field that is detected is much bigger than will be necessary to switch the detector element 60, the detection cannot be affected by any possibly occurring interference. A good signal-to-noise ratio can be accomplished in this way.

### Reference numerals

- 10: contact
- 12: connector
- 15: switching chamber
- 16: housing
- 17: partition
- 18: terminal element
- 20: contact bridge
- 21: contact points
- 23: spring
- 24: projection
- 25: contact bridge carrier
- 26: motion link
- 27: stop
- 28: drive rod
- 40: blow magnet assembly
- 41: first blow magnet
- 42: sub-magnets
- 44: slot
- 45: magnetic field conducting elements
- 47: printed circuit board
- 48: component
- 50: detector
- 60: detector element
- 61: first detector element
- 62: second detector element
- 65: indicator element
- 66: permanent magnet
- 68: Hall sensor
- 70: two-point controller
- 71: first two-point controller
- 72: second two-point controller

- 80: output signal
- 81: first output signal
- 82: second output signal
- 94: magnetic field of the blow magnet assembly
- 96: magnetic field of the indicator element
- 100: switching assembly
- 111: first switching point of the first two-point controller
- 112: second switching point of the first two-point controller
- 121: first switching point of the second two-point controller
- 122: second switching point of the second two-point controller
- 151: first curve
- 152: second curve
- 160: contact area
- 161: overtravel area
- 171: movement curve of the contact bridge
- 172: movement curve of the contact bridge carrier
- 211: position associated with the first switching point of the first two-point controller
- 212: position associated with the second switching point of the first two-point controller
- 221: position associated with the first switching point of the second two-point controller
- 222: position associated with the second switching point of the second two-point controller
- 230: boundary of the malfunction area

- B: bridging position
- S: switching direction
- T: separated position
- U: tangential direction

## Claims

1. A switching assembly (100), in particular for the high-voltage and/or high-current range, with two contacts (10) and a contact bridge (20) movable from a bridging position (B), at which the contact bridge (20) connects the contacts (10) to one another in an electrically conductive manner, to a separated position (T), at which the contacts (10) are electrically separated from one another, wherein the switching assembly (100) comprises a detector (50) with at least one detector element (60, 61, 62) by means of which the presence of the contact bridge (20) at the separated position (T) and/or the bridging position (B) is detectable, **characterized in that** the detector (50) comprises at least one two-point controller (70, 71, 72) with a first switching point (111, 121) and a second switching point (112, 122) for the detector element (60, 61, 62), wherein at least one of the switching points (111, 112, 121, 122) is assigned to a position of the contact bridge (20) between the bridging position (B) and the separated position (T).

2. The switching assembly (100) according to claim 1, wherein both switching points (111, 112, 121, 122) are assigned to positions of the contact bridge (20) between the bridging position (B) and the separated position (T).

3. The switching assembly (100) according to claim 1, wherein the other switching point (111, 112, 121, 122) is assigned to the position of the contact bridge (20) at the bridging position (B) or the separated position (T).

4. The switching assembly (100) according to claim 1, wherein the separated position (T) or the bridging position (B) lies in an area located between positions (211, 212, 221, 222) assigned to the first switching point (111, 112, 121, 122) and the second switching point (112, 111, 122, 121).

5. The switching assembly (100) according to one of the claims 1 to 4, wherein the contact bridge (20) is spring-mounted on a contact bridge carrier (25).

6. The switching assembly (100) according to one of the claims 1 to 5, wherein the switching assembly (100) comprises an indicator element (65), the position of which is detectable by the detector element (60, 61, 62).

7. The switching assembly (100) according to one of the claims 1 to 6, wherein the switching assembly (100) comprises a further detector element (60, 62, 61).

8. The switching assembly (100) according to one of the claims 1 to 7, wherein the switching assembly (100) comprises two two-point controllers (70, 71, 72) for each detector element (60, 61, 62).

9. The switching assembly (100) according to one of the claims 1 to 8, wherein the at least one detector element (60, 61, 62) is arranged outside a switching chamber (15).

10. The switching assembly (100) according to claim 6, wherein the indicator element (65) comprises a permanent magnet (66).

11. The switching assembly (100) according to one of the claims 1 to 10, wherein the at least one detector element (60, 61, 62) comprises a Hall sensor (68).

12. The switching assembly (100) according to one of the claims 1 to 11, wherein the at least one detector element (60, 61, 62) is arranged on a printed circuit board (47).

13. The switching assembly (100) according to one of the claims 1 to 12, wherein the at least one detector element (60, 61, 62) is arranged in a slot (44) in a blow magnet assembly (40).

14. The switching assembly (100) according to one of the claims 1 to 13, wherein the difference in signal strengths occurring in the measurement is greater by at least a factor of 5 than the difference in signal strengths that is necessary for getting from the first switching point (111, 112, 121, 122) to the second switching point (112, 111, 122, 121) of the detector element (60).

15. A method of measuring a position of a contact bridge (20) in a switching assembly (100) according to claim 1, **characterized in that**, when the contact bridge (20) moves from the bridging position (B) to the separated position (T), switching from a first output signal (81) to a second output signal (82) takes place at a first switching point (111, 112, 121, 122) and, when the contact bridge (20) moves from the separated position (T) to the bridging position (B), switching from the second output signal (82) to the first output signal (81) takes place at a second switching point (112, 111, 122, 121) that is different from the first switching point (111, 112, 121, 122), at least one of the switching points (111, 112, 121, 122) being assigned to a position of the contact bridge (20) between the bridging position (B) and the separated position (T).

## Patentansprüche

1. Schaltanordnung (100), insbesondere für den Hochspannungs- und/oder Hochstrombereich, mit zwei Kontakten (10) und einer Kontaktbrücke (20), die von einer Überbrückungsposition (B), in der die Kontaktbrücke (20) die Kontakte (10) elektrisch leitend miteinander verbindet, in eine Trennposition (T) bewegbar ist, in der die Kontakte (10) elektrisch voneinander getrennt sind, wobei die Schaltanordnung (100) einen Detektor (50) mit mindestens einem Detektorelement (60, 61, 62) umfasst, durch den das Vorhandensein der Kontaktbrücke (20) an der getrennten Position (T) und/oder der Überbrückungsposition (B) erfassbar ist, **dadurch gekennzeichnet, dass** der Detektor (50) mindestens einen Zweipunktregler (70, 71, 72) mit einem ersten Schaltpunkt (111, 121) und einem zweiten Schaltpunkt (112, 122) für das Detektorelement (60, 61, 62) aufweist, wobei mindestens einer der Schaltpunkte (111, 112, 121, 122) einer Position der Kontaktbrücke (20) zwischen der Überbrückungsposition (B) und der Trennposition (T) zugeordnet ist.

2. Schaltanordnung (100) nach Anspruch 1, wobei beide Schaltpunkte (111, 112, 121, 122) Positionen der Kontaktbrücke (20) zwischen der Überbrückungsposition (B) und der Trennposition (T) zugeordnet sind.

3. Schaltanordnung (100) nach Anspruch 1, wobei der andere Schaltpunkt (111, 112, 121, 122) der Position der Kontaktbrücke (20) in der Überbrückungsposition (B) oder der Trennposition (T) zugeordnet ist.

4. Schaltanordnung (100) nach Anspruch 1, wobei die getrennte Position (T) oder die Überbrückungsposition (B) in einem Bereich liegt, der zwischen den Positionen (211, 212, 221, 2 222), die dem ersten Schaltpunkt (111, 112, 121, 122) und dem zweiten Schaltpunkt (112, 111, 122, 121) zugeordnet sind.

5. Schaltanordnung (100) nach einem der Ansprüche 1 bis 4, wobei die Kontaktbrücke (20) an einem Kontaktbrückenträger (25) federnd gelagert ist.

6. Schaltanordnung (100) nach einem der Ansprüche 1 bis 5, wobei die Schaltanordnung (100) ein Anzeigeelement (65) umfasst, dessen Position durch das Detektorelement (60, 61, 62) erfassbar ist.

7. Schaltanordnung (100) nach einem der Ansprüche 1 bis 6, wobei die Schaltanordnung (100) ein weiteres Detektorelement (60, 62, 61) umfasst.

8. Schaltanordnung (100) nach einem der Ansprüche 1 bis 7, wobei die Schaltanordnung (100) für jedes Detektorelement (60, 61, 62) zwei Zweipunktregler (70, 71, 72) umfasst.

9. Schaltanordnung (100) gemäß einem der Ansprüche 1 bis 8, wobei das mindestens eine Detektorelement (60, 61, 62) außerhalb einer Schaltkammer (15) angeordnet ist.

10. Schaltanordnung (100) gemäß Anspruch 6, wobei das Anzeigeelement (65) einen Permanentmagneten (66) umfasst.

11. Schaltanordnung (100) nach einem der Ansprüche 1 bis 10, wobei das mindestens eine Detektorelement (60, 61, 62) einen Hallsensor (68) umfasst.

12. Schaltanordnung (100) nach einem der Ansprüche 1 bis 11, wobei das mindestens eine Detektorelement (60, 61, 62) auf einer Leiterplatte (47) angeordnet ist.

13. Schaltanordnung (100) nach einem der Ansprüche 1 bis 12, wobei das mindestens eine Detektorelement (60, 61, 62) in einem Schlitz (44) in einer Blasmagnetenbaugruppe (40) angeordnet ist.

14. Schaltanordnung (100) nach einem der Ansprüche 1 bis 13, wobei die bei der Messung auftretende Differenz der Signalstärken um mindestens den Faktor 5 größer ist als die Differenz der Signalstärken, die notwendig ist, um vom ersten Schaltpunkt (111, 112, 121, 122) zum zweiten Schaltpunkt (112, 111, 122, 121) des Detektorelements (60) erforderlich ist.

15. Verfahren zum Messen einer Position einer Kontaktbrücke (20) in einer Schaltanordnung (100) gemäß Anspruch 1, **dadurch gekennzeichnet, dass**, wenn sich die Kontaktbrücke (20) von der Überbrückungsposition (B) zur Trennposition (T) bewegt, Schalten an einem ersten Schaltpunkt (111, 112, 121, 122) von einem ersten Ausgangssignal (81) zu einem zweiten Ausgangssignal (82) erfolgt und, wenn sich die Kontaktbrücke (20) von der Trennposition (T) zur überbrückenden Position (B) bewegt, Schalten vom zweiten Ausgangssignal (82) zum ersten Ausgangssignal (81) an einem zweiten Schaltpunkt (112, 111, 122, 121) erfolgt, der sich vom ersten Schaltpunkt (111, 112, 121, 122) unterscheidet, wobei mindestens einer der Schaltpunkte (111, 112, 121, 122) einer Position der Kontaktbrücke (20) zwischen der Überbrückungsposition (B) und der Trennposition (T) zugeordnet ist.

## Revendications

1. Ensemble de commutation (100), en particulier pour la plage des hautes tensions et/ou d'intensités élevées, ayant deux contacts (10) et un pont de contact (20) mobile depuis une position de pontage (B), à laquelle le pont de contact (20) raccorde les contacts (10) l'un à l'autre d'une manière électriquement conductrice, jusqu'à une position séparée (T), à laquelle les contacts (10) sont électriquement séparés l'un de l'autre, dans lequel l'ensemble de commutation (100) comprend un détecteur (50) avec au moins un élément détecteur (60, 61, 62) grâce auquel la présence du pont de contact (20) à la position séparée (T) et/ou la position de pontage (B) peut être détectée, **caractérisé en ce que** le détecteur (50) comprend au moins un contrôleur en deux points (70, 71, 72) avec un premier point de commutation (111, 121) et un second point de commutation (112, 122) pour l'élément détecteur (60, 61, 62), dans lequel au moins l'un des points de commutation (111, 112, 121, 122) est attribué à une position du pont de contact (20) entre la position de pontage (B) et la position séparée (T).

2. Ensemble de commutation (100) selon la revendication 1, dans lequel les deux points de commutation (111, 112, 121, 122) sont attribués à des positions du pont de contact (20) entre la position de pontage (B) et la position séparée (T).

3. Ensemble de commutation (100) selon la revendication 1, dans lequel l'autre point de commutation (111, 112, 121, 122) est attribué à la position du pont de contact (20) au niveau de la position de pontage (B) ou de la position séparée (T).

4. Ensemble de commutation (100) selon la revendication 1, dans lequel la position séparée (T) ou la position de pontage (B) repose dans une zone localisée entre des positions (211, 212, 221, 222) attribuées au premier point de commutation (111, 112, 121, 122) et au second point de commutation (112, 111, 122, 121).

5. Ensemble de commutation (100) selon l'une des revendications 1 à 4, dans lequel le pont de contact (20) est monté sur ressort sur un support de pont de contact (25).

6. Ensemble de commutation (100) selon l'une des revendications 1 à 5, dans lequel l'ensemble de commutation (100) comprend un élément indicateur (65), dont la position peut être détectée par l'élément détecteur (60, 61, 62).

7. Ensemble de commutation (100) selon l'une des revendications 1 à 6, dans lequel l'ensemble de commutation (100) comprend un élément détecteur supplémentaire (60, 62, 61).

8. Ensemble de commutation (100) selon l'une des revendications 1 à 7, dans lequel l'ensemble de commutation (100) comprend deux contrôleurs en deux points (70, 71, 72) pour chaque élément détecteur (60, 61, 62).

9. Ensemble de commutation (100) selon l'une des revendications 1 à 8, dans lequel le au moins un élément détecteur (60, 61, 62) est agencé à l'extérieur d'une chambre de commutation (15).

10. Ensemble de commutation (100) selon la revendication 6, dans lequel l'élément indicateur (65) comprend un aimant permanent (66).

11. Ensemble de commutation (100) selon l'une des revendications 1 à 10, dans lequel le au moins un élément détecteur (60, 61, 62) comprend un capteur de Hall (68).

12. Ensemble de commutation (100) selon l'une des revendications 1 à 11, dans lequel le au moins un élément détecteur (60, 61, 62) est agencé sur une carte de circuit imprimé (47).

13. Ensemble de commutation (100) selon l'une des revendications 1 à 12, dans lequel le au moins un élément détecteur (60, 61, 62) est agencé dans une fente (44) dans un ensemble aimant de soufflage (40).

14. Ensemble de commutation (100) selon l'une des revendications 1 à 13, dans lequel la différence dans les forces de signal survenant dans la mesure est supérieure d'au moins un facteur de 5 à la différence dans des forces de signal qui est nécessaire pour aller du premier point de commutation (111, 112, 121, 122) au second point de commutation (112, 111, 122, 121) de l'élément détecteur (60).

15. Procédé de mesure d'une position d'un pont de contact (20) dans un ensemble de commutation (100) selon la revendication 1, **caractérisé en ce que**, lorsque le pont de contact (20) se déplace depuis la position de pontage (B) vers la position séparée (T), la commutation d'un premier signal de sortie (81) vers un second signal de sortie (82) a lieu au niveau d'un premier point de commutation (111, 112, 121, 122) et, lorsque le pont de contact (20) se déplace depuis la position séparée (T) vers la position de pontage (B), la commutation du second signal de sortie (82) au premier signal de sortie (81) a lieu au niveau d'un second point de commutation (112, 111, 122, 121) qui est différent du premier point de commutation (111, 112, 121, 122), au moins l'un des points de commutation (111, 112, 121, 122) étant attribué à une position du pont de contact (20) entre la position de pontage (B) et la position séparée (T).
